# EUROPEAN PATENT APPLICATION

(11) **EP 4 711 785 A1**
(43) Date of publication of application: **18.03.2026**
(21) Application number: 24200611.2
(22) Date of filing: 16.09.2024
(51) Int. Cl.: G01R 31/389

(54) **BATTERY EXCITATION UNIT FOR IMPEDANCE MEASUREMENTS**

(71) Applicant: Heimdalytics GmbH, 24145 Kiel (DE)
(72) Inventor: VAN ZEYL, Clemens, Oakvil, L6J 3Y5 (CA); WEBER, Dr. Christoph, 24149 Kiel (DE); KRONENBERG, Felix, 24116 Kiel (DE); PFAFF, Jakob, 24149 Kiel (DE)
(74) Representative: Maiwald GmbH

(57) **Abstract**

The invention relates to an an EIS measurement system is provided. The EIS measurement system comprises a battery excitation unit, BXU, (1320) incorporating a bidirectional voltage controlled current source for injecting current into a String of Battery Cell Units consisting of Battery Cell Units (1001, 1002) (a "Battery String") of the battery for an EIS measurement, and at least one Offset Voltage Device (OVD) (1350). The BXU is connected in series with the at least one OVD, each of which is configured to provide a voltage with opposite polarity to the Battery String to act as an Offset Voltage to the internal voltage of the Battery Cell Units within the Battery String, such that the BXU largely sees the impedance of the Battery Cell Units within the Battery String to be measured.

## Description

### Field of the Invention

The invention relates to a system for electrical impedance spectrometry ("EIS") measurement. The EIS measurement system includes a battery excitation unit ("BXU") for exiting a battery for the purpose of measuring impedance in conjunction with a battery measurement unit ("BMU") for measuring the voltage of a single cell or multiple cells, which are typically connected in parallel (a "Battery cell unit").

### Background

For an EIS measurement, multi-sinusoidal current signals are usually injected by the BXU in a battery system, which serve as an excitation-function. Due to the excitation, the Battery cell units within the battery system also react with a multi-sinusoidal voltage response of different amplitudes and phase shifts as measured by the BMU. The ratio of the voltages and the current in the frequency domain represents the impedance spectra of the cells measured by the BMU. Typically, a Battery cell unit has an independent BXU to inject the excitation current combined with a measurement circuit within the BMU. A plurality of Battery cell units can be electrically connected in series to form a string of Battery cell units (a "Battery String"). Hence, typically there is a plurality of BXU excitation sources and a plurality of BMU for measurement circuits within a Battery String. For clarity, this definition is independent of how the Battery cell units are physically packaged within the Battery String. For example, a plurality of Battery cell units can be package in a battery module, and in turn a plurality of battery modules connected in a series string to be an electrically connected Battery String. For further clarity, several BXUs can be physically and electrically packaged together to form a multi-channel BXU and several BMUs can be physically and electrically packaged together to form a multi-channel BMU. Herein, a BXU and BMU refers to a unit with a single-channel.

### Summary of the Invention

There may be a desire to provide an improved system to perform the excitation function of a Battery String.

The problem is solved by the subject-matter of the independent claims. Embodiments are provided by the dependent claims, the following description, and the accompanying figures.

The described embodiments similarly pertain to the EIS measurement system and the use of a BXU. Synergetic effects may arise from different combinations of the embodiments although they might not be described in detail.

Further on, it shall be noted that all embodiments of the present invention concerning a method might be carried out with the order of the steps as described, nevertheless this has not to be the only and essential order of the steps of the method. The herein presented methods can be carried out with another order of the disclosed steps without departing from the respective method embodiment, unless explicitly mentioned to the contrary hereinafter.

Technical terms are used by their common sense. If a specific meaning is conveyed to certain terms, definitions of terms will be given in the following in the context of which the terms are used.

According to a first aspect, an EIS measurement system is provided. The EIS measurement system comprises a battery excitation unit, BXU, incorporating a bidirectional voltage controlled current source for injecting current into a String of Battery Cell Units consisting of Battery Cell Units (a "Battery String") of the battery for an EIS measurement, and at least one Offset Voltage Device (OVD). The BXU is connected in series with the at least one OVD, each of which is configured to provide a voltage with opposite polarity to the Battery String to act as an Offset Voltage to the internal voltage of the Battery Cell Units within the Battery String, such that the BXU largely sees the impedance of the Battery Cell Units within the Battery String to be measured.

In other words, an EIS measurement system is provided for Battery cell units of a battery which are switchable. The EIS measurement system comprises a single BXU incorporating a bidirectional voltage controlled current source for injecting current into the composed Battery String for an EIS measurement. The EIS measurement system comprises further devices producing an offset to the internal voltage of the Battery Cell Units within the Battery String (an "Offset Voltage"), herein referred to as "Offset Voltage Devices". The OVD reduces the necessary DC voltage generated by the BXU to act as a current source such that the BXU largely sees the impedance of the Battery Cell Units within the Battery String to be measured. For example, a BXU may have a voltage capability of 50 V, whereas a Battery String could have a maximum voltage of 68 V (the typical voltage of an NMC battery module with 16 Battery cell units connected in a string). In this example, the Offset Voltage Device would need to be at least a constant 18V but ideally the nominal voltage of the Battery String (approximately 58V). In another example, the nominal voltage of a Battery String could be 580 V. In this example, the ideal Offset Voltage Device would be a constant 580V. The single BXU, the one or more voltage sources and the Battery cell units of the Battery String are connected in series, such that they form a ring or "EIS measurement loop". The order of these devices can be in any arbitrary way.

That is, by providing a constant Offset Voltage, the BXU only has to provide the voltage difference between the Offset Voltage and the internal voltage of the Battery cell units within the Battery String to be measured, which again results in moderate voltage to be generated by the BXU. Therefore, also the power rating of the BXU can be decreased. The term "such that" in "such that the BXU largely sees the impedance of the Battery Cell Units within the Battery String to be measured" shall therefore be understood as a result of providing an Offset Voltage, not as a constraint.

According to an embodiment, the EIS measurement system further comprises one or more BMUs, each associated a Battery cell unit to measure the voltage response of its corresponding Battery cell unit and to perform the EIS measurement of each Battery cell unit.

According to an embodiment, the EIS measurement system further comprises a current sensor (1326) for measuring the EIS current and which is used for the excitation of the EIS current into the battery-string.

For an impedance measurement of the Battery cell units within a Battery String, the voltage response and the current have to be measured. If there is a single current path that includes the Battery String and the BXU current source, the current can be measured anywhere in this path. Preferably, the current is measured by a measurement circuit internal to the BXU, so that no additional current measurement device is required. The voltage response of each Battery cell unit in the path is measured by its corresponding BMU. Since the impedance measurement depends on the phase shift between excitation current and voltage response of the Battery cell units to be measured, synchronization of the current and voltage measurements is required. The synchronization may be accomplished by the current measurement circuit of the BXU. For example, the current measurement circuit generates a synchronization signal for the BMU(s). A second example is a signal generated by a clock used for the digital circuits in the system, such as microprocessors. Alternatively, other known synchronization methods may be used such as using GNSS signals or similar.

BMUs are usually already available in Batteries and configured, among further battery management tasks, to perform voltage measurements. Usually, one Battery cell unit is connected to one BMU. However, a BMU may also manage and measure the voltage of more than one Battery cell unit.

According to an embodiment, the at least one Offset Voltage Device is a voltage source, including, but not limited to, a power supply or other battery.

In such Power Supply Offset Configurations, the controllable power supply or voltage source may be configured such that is provides the required opposite voltage. As mentioned above, each of these devices can be positioned at any place in the EIS measurement loop.

According to a further embodiment, the voltage of the power supply voltage source may be adjusted as a function of the state of charge or open circuit voltage of the Battery String to be measured thereby minimizing the voltage differential between the Offset Voltage Device and the internal voltage of the Battery cell units within the Battery String.

According to an embodiment, at least one of the Offset Voltage Devices is a Battery Cell Unit.

Some of the Battery Cell Units within the EIS Measurement Loop may be connected with opposite polarity such that they provide an Offset Voltage for each other. In the case where an even number of Battery cell units within an EIS Measurement Loop are paired with opposite polarity, a power supply or a voltage source as Offset Voltage Device need not be provided

According to an embodiment, the EIS measurement system further comprises a switching matrix configured to be controlled such that, for an EIS measurement, at least one of the Battery Cell Units is switched into the Battery String in series with the BXU.

The switching matrix may consist of at least one switch. In preferred embodiments, the switching matrix comprises two switches. In further preferred embodiments, the matrix comprises a plurality of switches. In a full switching matrix, any Battery Cell Unit may be added to the EIS Measurement Loop, (i.e. into the Battery String to be measured), either with normal polarity or with opposite polarity.

According to an embodiment, the switching matrix is configured to be controlled such that, for an EIS measurement, at least one of the OVDs is switched into the Battery String in series with the BXU.

In other words, also a controllable voltage source or power supply can be inserted into the EIS Measurement Loop by the switching matrix.

According to an embodiment, the switching matrix is configured to be controlled such that, for an EIS measurement, a first Battery String of the Battery Assembly is switched into the Battery String Assembly, i.e., the EIS measurement loop, and a second Battery String of the Battery Assembly is switched into the Battery Assembly as Offset Voltage Device

As an example, to implement an EIS Measurement Loop in a Power Supply Offset Configuration, the measurement system may comprise a first switchable EIS-Interconnection connecting the BXU to the minus terminal of the Battery String, and a second switchable EIS-Interconnection connecting the plus terminal of power supply voltage source to the plus terminal of the Battery String. During the measurement, the Battery String is isolated form its interconnected system utilizing main switches and the first and the second switchable EIS-interconnections are configured to be switched on when the current injection takes place. The BXU is configured to inject the current into the minus terminal of power supply voltage source and hence the positive terminal of the Battery String (or vice versa). The common of the circuit maybe grounded or ungrounded.

According to an embodiment, the switching matrix comprises main switches that connect two parallel connected Battery Strings to an interconnected DC system. The two Battery Strings connected in parallel, each of which is composed of several Battery Cell Units, is inserted with opposite polarity into the EIS measurement loop, and the two Battery Strings are used for providing the Offset Voltage for measurement of the two Battery Strings. Hence, one Battery String thus acts as an Offset Voltage for the other. This configuration may also be referred to as a "Parallel Battery Offset Configuration".

As an example, to implement an EIS Measurement Loop in a Parallel Battery Offset Configuration with two Battery Strings connected in parallel when in operation, the measurement system further comprises a first switchable EIS-Interconnection connecting the BXU to the minus terminal of the second Battery String, and a second switchable EIS-Interconnection connecting the plus terminal of a first Battery String to the plus terminal of a second Battery String. During the measurement, the parallel connected Battery Strings are isolated from its interconnected system by opening main switches and the first and the second switchable ElS-interconnections are configured to be switched on when the current injection takes place. The BXU is configured to inject the current into the Battery Assembly or two Battery Strings with their plus terminals connected together and the BXU connected in between their minus terminals (or vice versa). The common of the circuit maybe grounded or ungrounded.

In general, this concept can be extended to more than two parallel connected Battery Strings.

According to an embodiment, the switching matrix is configured to be controlled such that, for an EIS measurement, a Battery String of the Battery Assembly is divided into a first battery string half and a second battery string half, wherein the second battery string half is switched as Offset Voltage Device.

As an example, a Battery String is configured as two half-strings, a positive half (a "Positive Half String") and a negative half (a "Negative Half String") with a switch in between the negative of the Positive Half String and the positive of the Negative Half String. The Voltage Offset Device for measurement of the Positive Half String is the Negative Half String of opposite polarity, or vice versa, such that one half string acts as an Offset Voltage for the other half string. This configuration may also be referred to as "Half String Offset Configuration".

In particular, to implement an EIS Measurement Loop in a Half String Offset Configuration with the Positive Half String and Negative Half String connected in series when in operation, the measurement system further comprises a first switchable EIS-Interconnection connecting the BXU to the minus terminal of the Positive Half String, and a second switchable EIS-Interconnection connecting the plus terminal of the Positive Half String to the plus terminal of the Negative Half String. During the measurement, the series connected Positive Half String and Negative Half String are isolated form its system utilizing main switched and the first and the second switchable ElS-interconnections are configured to be switched on when the current injection takes place. The BXU is configured to inject the current into the Positive Half String and Negative Half String with their plus terminals connected together and the BXU connected in between their minus terminals (or vice versa). The common of the circuit maybe grounded or ungrounded.

For the Half String Offset Configuration, the Offset Voltage of the Positive Half String and the Negative Half String may not be equal (balanced). In this case there is a differential voltage between the two half Battery Strings. The Offset Voltage Device reduces the necessary DC voltage of the BXU to act as a current source such that the BXU largely sees the impedance of the Battery cell units within the Battery String to be measured. For example, a BXU may have a voltage capability of 50 V, whereas the differential voltage between the two half Battery Strings could have a maximum voltage of 68 V. In this example, the Offset Voltage Device would need to be at least a constant 18V but ideally the nominal voltage of the differential voltage (approximately 58V). A constraint is, that the differential voltage between the two halves does not exceed the voltage capacity of the BXU. For example, a BXU may have a voltage capability of 50 V, whereas the voltage differential could have a maximum voltage of 68 V, equaling the voltage of a typical NMC Battery String with 16 Battery cell units (i.e., one half string has an additional Battery String). In this example, an additional Offset Voltage Device would need to offset the differential voltage within the capability of the BXU.

According to an embodiment, in case of stationary impedance spectrometry measurement, the main switches are open such that at least one Battery String is disconnected from an interconnected DC system.

The interconnected system comprises for example a DC rail which is connected at least during operation of the battery on one side directly or via a converter to the Battery String, and on the other side for example, to a load or generator. "Stationary" means that the Battery String or Battery Strings to be measured are isolated during the EIS measurement.

According to an embodiment, in case of dynamic impedance spectrometry measurement, the main switches are closed such that at least one Battery String is connected to the interconnected DC system and the is Battery String operable during the EIS measurement.

According to an embodiment, the additional Offset Voltage of an unbalanced half Battery Strings in a "Half String Offset Configuration" could be provided by a power supply voltage source, controllable or uncontrollable.

That is, the measurements are performed during operation of the Battery String. In this case current flows from its interconnected system ("System Current Flow"), and the excitation current is superimposed on the current flow from the system through the Battery String(s), with additional analytical complexity of the EIS measurement. This is referred to as "Dynamic Spectrometry".

According to an embodiment, the EIS measurement system for Dynamic Spectrometry is configured to place a current sensor for the excitation in series with a terminal of the Battery String to be measured such that it measures the current flow from its interconnected system (i.e., with the main switches closed), and the BXU.

A second current sensor measures the current flow from the interconnected system, and hence the excitation current is then derived from the two current flow measurements (the "Derived Excitation Current"). The BXU is connected in series with an Offset Voltage Device (e.g. a power supply voltage source), and the Offset Voltage Device is connected to the terminal of the current sensor for the excitation (opposite terminal from the Battery String(s). The EIS measurement system is configured to perform EIS measurements during the operation of the Battery String(s). with the BXU controlled by the Derived Excitation Current feedback

In embodiments, in the case of Dynamic Spectrometry, to reduce complexity of the EIS measurement analysis and improve the accuracy of the Derived Excitation Current, using an DC to AC or DC to DC converter ("Converter" or "CNV") to control the current flow between the interconnected system and the Battery String(s) to be measured. During an EIS measurement, the current flow from the interconnected system can be held constant. In this case, any additional current flow demanded by the interconnected system can be delivered from any other interconnected Battery String not being measured.

In embodiments, in the case of Static Spectrometry to manage the current inrush when reconnecting a Battery String to an interconnected system after an EIS measurement, a Converter may be used to control the current flow of a Battery String. Another method to maintain inrush current within acceptable levels is to abort an EIS measurement if the voltage differential between the interconnected system and the Battery String(s) isolated for measurement exceeds a pre-determined value. Using this method, EIS measurements would only occur during periods of low current flow demanded by the interconnected system. Another method is to temporality insert a current limiting device, for example a resistor, in series with the Battery String to limit the current inrush.

In embodiments, the BXU further comprises a voltage sensor at the output of the voltage controlled current source, and, in case of a Static Spectrometry impedance measurement, the EIS measurement system includes a current sensor within a current path from or to the voltage controlled current source. In case of a Dynamic Spectrometry impedance measurement, the EIS measurement system comprises a current sensor in series with the interconnected system and a second current sensor within a current through the Strings(s) to be measured.

According to an embodiment, the bidirectional voltage controlled current source for the BXU may be realized by an operational amplifier ("Op Amp"). An Op Amp can be used since the voltage difference due to the Offset Voltage Device is in a range that can be compensated by an Op Amp. The Op Amp is wired such that it realizes a voltage controlled current source. The voltage may be a multi-sinusoidal voltage generated by a controller including a digital to analog converter.

According to an embodiment, instead of an Op Amp, a converter (e.g., a DC/DC converter), or other means of generating a current source may be used as a bidirectional voltage controlled current source for the BXU.

According to a further aspect, one or more BMUs, i.e., impedance measurement devices, and a BXU, i.e., a voltage controlled current source, in an EIS measurement system as described herein is proposed.

The proposed EIS measurement system allows to excite a multi-sinusoidal current excitation for batteries with voltages of several hundred volts. The BXU represents a voltage controlled active current source with a plus and minus output current capability to inject the multi-sinusoidal current into a Battery String for EIS (electrochemical impedance spectrometry) measurements. The BXU is interconnected between a Battery String or various series or parallel configurations of Battery Strings along with an Offset Voltage such that its output voltage largely has to compensate for the voltage drop across the impedance of the Battery cell units being measured. In the preceding, "largely" means the Offset Voltage may not completely offset the internal voltage of the Battery cell units being measured, and this differential voltage is compensated for by the BXU.

The EIS measurement system may further comprise a control unit. The control unit may comprise for example one or more microcontrollers, a data memory and wired or wireless communication circuits to communicate with the BXU and the BMUs. The control unit may include the controller as described herein. Alternatively, the controller and the control unit are different devices. The control unit may receive the measurements, i.e. the detect measured variables for determining a state of the Battery cell units. It may organize the received data in data sets. Alternatively, instead of receiving the data directly from the BXU or the BMUS, it may receive the data from one or more measurement units each of which is responsible to collect the data from a battery cell or a battery cell unit that contains more than one battery cell and the BXU, and which organizes the data in data sets. The measurement units may be capable of determining the impedance spectrum such that it can provide the already calculated impedance spectrum to the control unit.

The data sets may therefore comprise for each battery cell or battery cell unit the measured currents and voltages per frequency and/or the impedance spectrum values, and a time stamp. The data sets may further contain further data such as temperature measured at the battery or environment and other data such as pressure in the battery cell unit, humidity, chemical and physical parameters.

By the EIS measurement, a state of the battery is determined. A state is, for example, a state of charge or a "state of health", or a physical or chemical property that can change through the use of the battery or generally over time.

The battery control unit may be configured to generate a feature data set from the measurement data sets of the measurement units, to apply a time stamp to the feature data set and to temporarily store, i.e. cache, the feature data set including the time stamp. In addition to the time stamp, the characteristic data set can contain, for example, impedance values at frequency support points, as well as current and voltage values, statistical information on measured current and voltage ranges, an SoC, calculated by means of a current integration over the time interval between the last measurement and the current measurement, a temperature, etc.

The EIS measurement system may further comprise a computing unit and a communication interface, which can be, for example, a local or wired interface, such as Ethernet, or a wireless interface, such as WiFi, Bluetooth, LTE, 5G, radio, cloud, which are configured to transmit the cached feature data records from the battery control unit to the computing unit, e.g. a server or a cloud service, whereby the computing unit is configured to receive the temporarily stored feature data records and to calculate a model of a machine learning system cyclically or dynamically on the basis of current feature data records, whereby the model provides diagnostic functions for each measuring unit, and the computing unit is also configured to transmit the model to the battery control unit via the communication interface. The computing unit, e.g. a cloud computer, server or controller, stores all characteristic data records with a time stamp in a database. This creates a digital life/health record that can be used to seamlessly monitor the most important features of the battery system. Even at this stage of the data situation, anomalies in the battery system can be detected at cell unit level through simple checks of range limits. The computing unit also makes it possible to train updated models using machine learning methods on the basis of the latest feature data sets (e.g. from the last 6 months).

The battery control unit may be equipped with logic that allows diagnostic functions to be executed. The diagnostic functions are based on a model of a machine learning process. The battery control unit receives the model or the values of the model parameters via a wireless interface, or alternatively via a wired interface from a computing unit, as described in more detail below. The logic may include hardware and/or software elements. It is understood that the battery control unit can have hardware such as processors, logic modules, program memories and registers, clock modules, etc., depending on its tasks. The diagnostic functions relate in particular to characteristics of the interior of the battery, current statistics, etc. Examples of diagnostic functions are the current state of charge (SoC), the state of health (SoH), the temperature of the cell core or even a default (recommended) value for the upcoming maximum power output/input of the battery system to protect it and extend its service life. The model does not necessarily have to provide all the diagnostic functions mentioned or provided. For example, the cell temperature can still be recorded directly by a temperature sensor.

This means that the computing unit regularly trains the model and sends the resulting model back to the battery control unit. The battery control unit then feeds the current characteristic data records into the model. This allows the battery control unit to provide important diagnostic functions that are periodically updated. Examples of diagnostic functions are the current state of charge (SoC), the state of health (SoH), the temperature of the cell core or even a default (recommended) value for the upcoming maximum power output/input of the battery system to protect it and extend its service life. The model does not necessarily have to provide all the diagnostic functions mentioned or provided. In the event that the battery control unit has sufficient computing capacity and memory space, in particular to store the history of the battery cell units, the function of the computing unit can be taken over by the battery control unit. The communication interfaces and units are not required in this case.

The model may be a model according to a recurrent (encoder/decoder) neural network method of known or future type, a reinforcement learning method such as Distributed Distributional/Deep Deterministic Policy Grading (D4DPG/DDPG) method and/or an actor/critic method, wherein the reinforcement learning method uses a reward for learning within an environment model.

The model may be an artificial intelligence model (e.g. of a neural network) that is configured to generate each time stamp from the feature data sets using the time stamps. This embodiment describes the reward function for learning the SoC diagnostic model. The agent of the neural network continuously estimates the future diagnostic value SoC between 0...100%. A difference value ΔSoC can also be estimated between directly adjacent timestamps. ΔSoC can therefore assume values between -100% and 100%. This ΔSoC value is also available in the coulomb counter of the battery control unit (integration of the current value) as a measured variable as a very precise variable. The comparison between the estimated ΔSoC and the measured ΔSoC values can be used in the environment model to evaluate/reward the "absolute SoC" diagnostic variable to be estimated. Since the SoC is technically limited between 0...100%, the learning procedure continuously improves not only the estimation of the ΔSoC, but also (indirectly) the estimation of the absolute SoC.

The model may be an artificial intelligence model that is further configured to estimate a SoC state value, a SoH state value, a state value with respect to a temperature, a chemical property and/or a physical property.

Artificial intelligence is also understood here as neural networks or machine learning.

In a variant, learning may also be supported by a simulation. Here, for example, software running on a PC or laptop runs through a predefined, typical performance profile, e.g. of a forklift truck or other means of transportation. The power unit has drivers that represent a power source and provide a charging current, or units that represent a load and absorb the battery current. As already described, the measurement data is sent to the computing unit in order to calculate the model or the values for the parameters of the model. After the learning phase, the model can be transferred to the battery control unit and used for real operation, e.g. of the means of transportation, and thus for continuous monitoring of the battery, e.g., during operation.

It can therefore be said that the generated models "live" and evolve with the individual operation of the battery system. The model generation therefore may be run, for example, during operation and independent of the cell chemistry used and the installation situation as well as the cabling properties and therefore independent of the contact resistances. Anomalies can be detected quickly and reliably by the model and the diagnostic functions in the battery control unit. This can be done, for example, by simple checks of range limits in the battery system at cell unit level. Furthermore, an individual digital life and/or health record can be created and maintained for each battery, with which the most important characteristics of the battery system can be monitored seamlessly, for example by the computer unit storing the characteristic data records with time stamps in a database accordingly.

According to a further aspect, a method for measuring an impedance in an EIS measurement system is provided, wherein the EIS measurement system comprises a battery excitation unit, BXU, incorporating a bidirectional voltage controlled current source for injecting current into a Battery String comprising a plurality of Battery Cell Units for an EIS measurement, and at least one Offset Voltage Device, OVD; and wherein battery excitation unit is connected in series with the at least one OVD, each of which is configured to provide a voltage with opposite polarity to the Battery String to act as an Offset Voltage to the internal voltage of the Battery Cell Units within the Battery String, such that the BXU largely sees the impedance of the Battery Cell Units within the Battery String to be measured. The method comprises the steps: injecting current into a Battery String; measuring the current through the Battery String and the voltage at least one of the Battery Cell Units.

These and other features, aspects and advantages of the present invention will become better understood with reference to the accompanying figures and the following description.

### Short description of the Figures

Fig. 1 shows a basic block diagram of an EIS measurement loop utilizing an Offset Voltage Device.
Fig. 2 shows a block diagram of an EIS measurement loop with pairs of battery cell units.
Fig. 3 shows a block diagram of an EIS measurement loop with pairs of battery cell units and an Offset Voltage Power Supply.
Fig. 4 shows a basic circuit diagram of an EIS measurement system utilizing an Offset Voltage Device.
Fig. 5 shows a circuit diagram of a BXU.
Fig. 6 shows a diagram of the EIS measurement system with a voltage source as Offset Voltage Device.
Fig. 7 shows a diagram of an embodiment of the EIS measurement system for dynamic measurements.
Fig. 8 shows a diagram of an embodiment of the EIS measurement system for stationary measurements with two battery strings.
Fig. 9a-c show diagrams of a remining voltage after offset and currents in the EIS measurement system of Fig. 8.
Fig. 10 shows a diagram of an embodiment of the EIS measurement system for stationary measurements with two battery string halves.
Fig. 11a-c show diagrams of a remining voltage after offset and currents in the EIS measurement system of Fig. 10.
Fig. 12 shows a diagram according to embodiments of the EIS measurement system including BMUs.
Fig. 13 illustrates the dynamic EIS configuration.
Fig. 14 shows a circuit diagram for dynamic EIS measurements.
Fig. 15 shows a flow diagram of a method for measuring an impedance in the EIS measurement system.
Fig. 16 shows a block diagram of a further embodiment of the EIS measurement system.

### Detailed description of embodiments

Corresponding parts are provided with the same reference symbols in all figures.

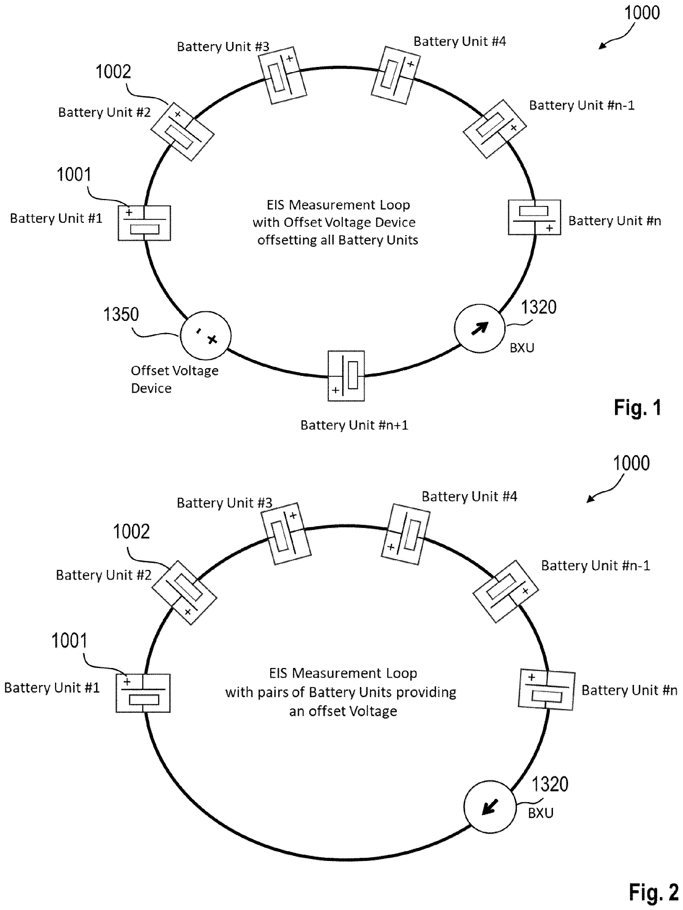

Fig. 1 shows a basic block diagram of an EIS measurement loop 1000 utilizing an Offset Voltage Device (OVD) 1350. The EIS measurement loop 1000, comprises a plurality of battery cell units 1001, 1002, the Offset Voltage Device 1350, and a BXU 1320. Each of the battery cell units 1001, 1002 may include one or mor battery cells. It is noted that only two battery cell units 1001, 1002 are provided with reference signs for reasons of clearness. The Offset Voltage Device 1350 may be an Offset Voltage Power Supply 1502. All these devices are connected in series such that they form a loop 1000. In principle, the location of a distinct device in the loop 1000 is arbitrary. The arrangement of batteries 1001, 1002 connected in series is also referred to a as string of battery cell units or Battery String. The Offset Voltage Device 1350 equalizes the voltage of the batteries, which are all batteries depicted in Fig.1. That is, it is configured to provide a voltage with opposite polarity to the Battery String to act as an Offset Voltage to the internal voltage of the Battery cell units 1001, 1002. In Fig. 1 only one OVD 1350 is shown. However, the loop 100 may contain more than one OVD 1350. The battery excitation unit (BXU) 1350 incorporates a bidirectional voltage controlled current source for injecting current into the Battery String.

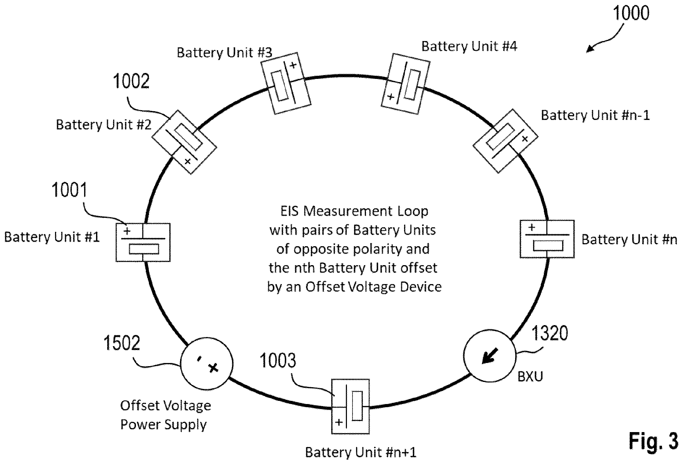

As shown in Fig. 2, the battery cell units 1001, 1002 themselves may be configured to act as OVD. In Fig. 2, this is accomplished by reversing the polarity of battery cell units, e.g., battery cell unit 1002 in Fig. 2. For example, the battery cell units 1001, 1002 can be switched as a string in such a way that two adjacent battery cell units 1001, 1002 form a pair. Since it can be supposed that the resulting voltage is relatively low, no extra Offset Voltage Power Supply is required. Nevertheless, an additional OVD may be used to equalize the remaining voltage. Such a case is shown in Fig. 3. As shown in the example of Fig. 3, the number of battery cells units 1001, 1002 may be unequal. For battery cell unit 1003 no second battery cell unit to from a pair is available. This is compensated by the Offset Voltage Power Supply 1502. In this case, the battery units with opposite polarity and the Offset Voltage Power Supply represent the OVD 1350.

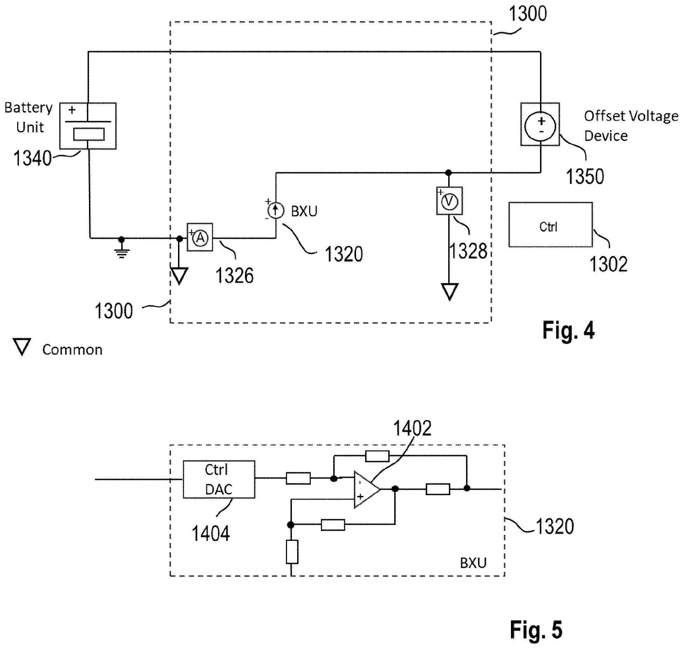

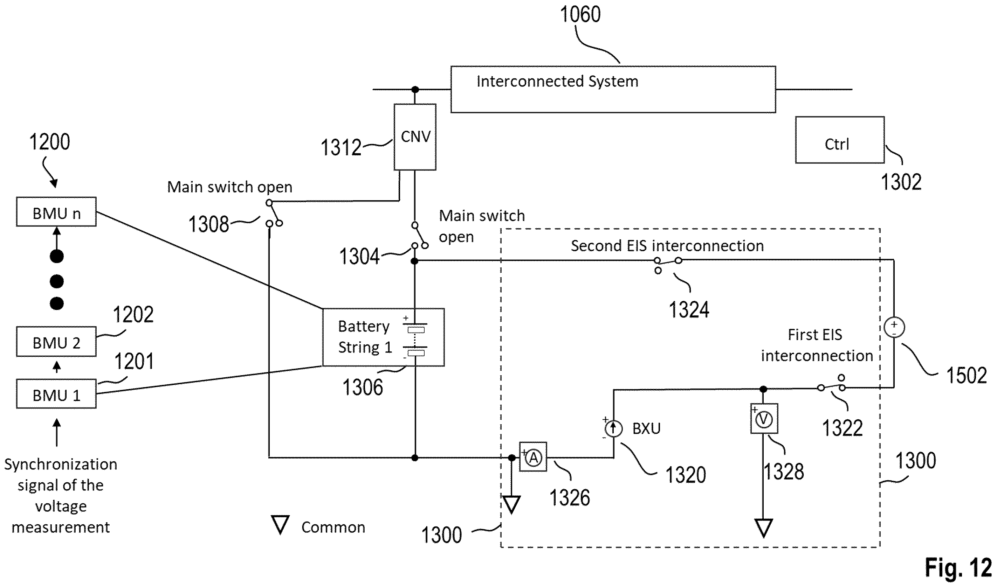

Fig. 4 shows a basic circuit diagram of the EIS measurement system. The EIS system comprises the BXU 1320 and the Offset Voltage Device 1350. The BXU 1320 is connected to the Offset Voltage Device 1350, which again is connected to the Battery cell unit 1340, representative for e.g. a Battery String containing several Battery cell units 1001, 1002 to be measured. The EIS loop is closed in that the Battery String 1340 is connected to the BXU 1320. The current flow is bi-directional. Fig. 4 shows an example where the multi-sinusoidal current that is generated by the BXU 1320 is flowing from the BXU 1320 to the minus pole terminal of the Offset Voltage Device 1350 acting voltage source, and further to the plus pole terminal of the Battery String 1340, and from the minus pole terminal of the Battery String 1340 again back to the BXU 1320, i.e., the current source 1320. Two sensors 1326, 1328 drawn into the diagram of Fig. 4. In Fig. 4, the BXU 1320 and the sensors 1326, 1328 are grouped into the dotted block 1300, which is also referred to as "BXU arrangement" in this disclosure. The first one is a current sensor 1326, and the second one is an optional voltage sensor 1328. It is noted that for the EIS measurement, current sensor 1326 is used and a battery management unit BMU, which is not shown in Fig. 4. In embodiments, the current sensor 1326 is arranged outside BXU arrangement 1300. Fig. 4 shows further a controller 1302 for controlling the operation of the EIS measurement system. The controller 1302 may be understood as a general control unit that may comprise one or more microcontrollers, memories, and further digital and analog circuits to fulfill the control tasks, as well as, for example a clock, and which may comprise logic or circuits for assisting the measurements. For example, the controller 1302 may be in communication with the BXU 1320 and the BMUs shown in Fig. 12, and may be responsible to collect the measurements, process the measurements or communication the measurement results or measurement data to further processing or communication units. Further possible tasks of the controller 1302 have been described above.

Fig. 4 shows a diagram of the voltage controlled bidirectional current source (BXU) 1320, which may be realized as shown in Fig. 5 as a circuit containing an operational amplifier 1402 wired to realize a voltage-controlled current source. A BXU controller 1404 generates a digital multi-sinusoidal voltage that is turned into an analog signal by a DAC. The analog voltage is provided to the OP that generates therefrom the multi-sinusoidal EIS current. The current source 1320 is suitable for high voltage batteries that enables the necessary current excitation with the aid of switchable supply lines, i.e., the EIS interconnections with switches 1324, 1322.

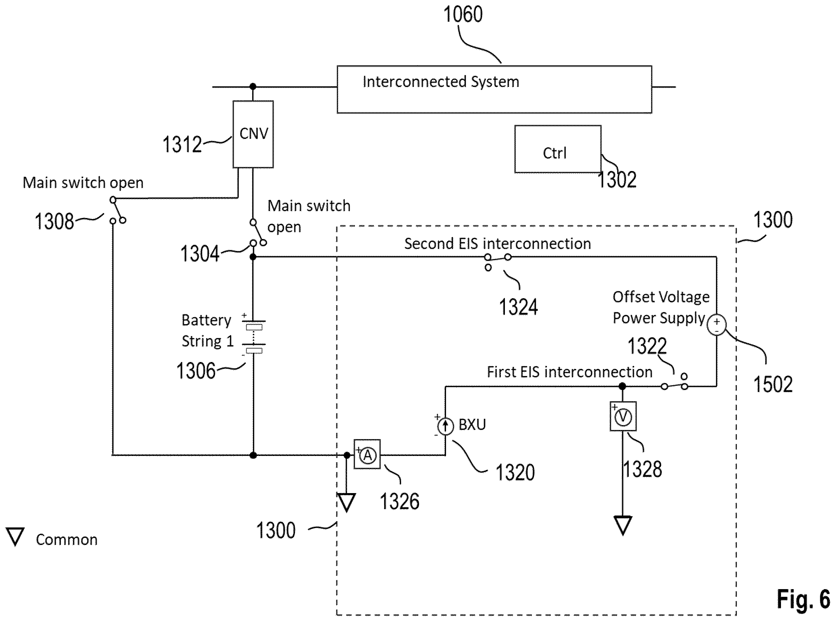

Fig. 6 shows an embodiment with a circuit diagram based on the circuit shown in Fig. 4. The Offset Voltage Device 1350 is realized in this embodiment by the controllable voltage source 1502. The Battery String in this embodiment is a first battery string 1306. Fig. 6 further shows EIS interconnection switches 1322 and 1324 as well as main switch 1304 at the plus pole terminal of battery string 1 and main switch 1308 at the minus pole terminal of the first battery string 1306, which can also be present in the circuit of Fig. 4.

The first EIS interconnection switch 1322 connects the output of the BXU 1320 with the minus terminal of the voltage source 1502. The second EIS interconnection switch 1324 connects the plus terminal of the voltage source 1502 with the plus terminal of the first battery string 1306. The EIS interconnection switches 1322, 1324 enable the EIS measurements, i.e. they are turned on during the EIS measurements. In this embodiment, main switches 1304, 1308 are open during the EIS measurements such that the Interconnected System 1060, e.g., a load or a charging circuit, is disconnected from the converter 1312, which may be a DC/DC converter or an AC/DC converter. This configuration is also referred to as stationary EIS measurements in this disclosure. Current sensor 1326 is inline in the single current loop between ground and the current source. The optional voltage sensor 1328 is located between the minus terminal of the voltage source 1502 and measures the voltage fluctuation resulting from the reaction of the first battery string 1306 on the multi-sinusoidal EIS injection current from the current source 1320 minus the voltage provided by the voltage source 1502. Again, controller 1302 is shown, which may be responsible for controlling at least the main switches 1304 and 1308, and which also may be used to control the first and second EIS interconnection switches 1322 and 1324 and to operate the converter 1312. The switches 1322, 1324 may be realized, for example, as semiconductor switches or relays.

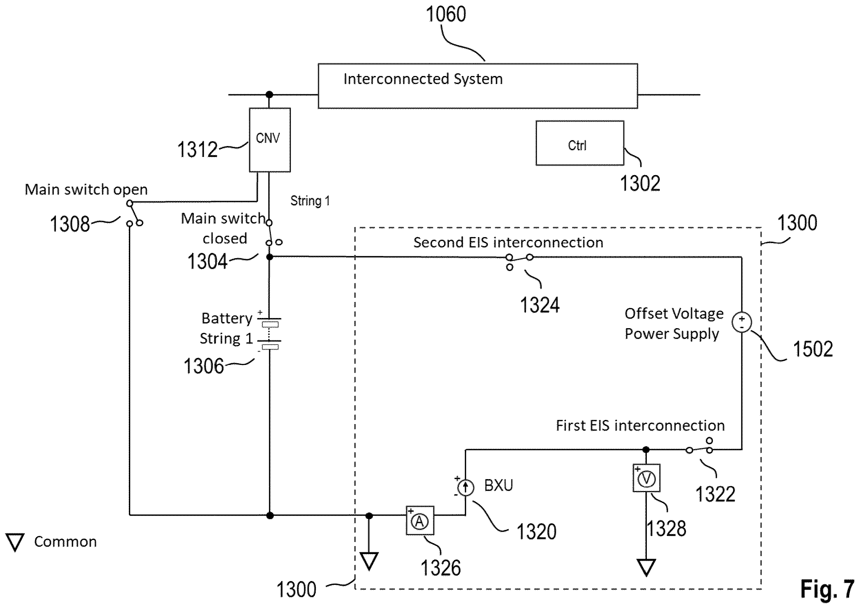

Fig. 7 shows an example with a circuit diagram similar to that of Fig. 6, however, with the difference that the converter 1312 is connected to the first battery string 1306 by closing main switch 1304. That is, the measurement can take place during the battery is used or charged. The current source in this case has to provide additionally the current leaking to the converter 1312. Therefore, in this case the BXU 1320 does not deliver a multi-sinusoidal current. It is clear that the BXU 1302 must be able to provide a sufficient current, if the actual impedance of the converter 1312 is much higher than the impedance of the battery string. This is the case, when the converter 1312 is in low power mode. The current sensor 1326 can be used to reference the BXU-Excitation current or to measure the injected current by the BXU 1320. In other words, the converter 1312 exhibits also an unknown impedance parallel to the battery string impedance. By means of the current sensor 1326 in the loop, it can be ensured that the correct current is delivered by the BXU 1320. In this case, the BXU 1320 has to drive both, the multi-sinusoidal current in the battery string and the leakage current over the converter 1312. It can be also possible to use the current sensor 1326 as a sensor for the string and the BXU 1320 delivers a pure multi-sinusoidal signal. Then, the impedance measurement is superimposed with the load current of the converter 1312. In this case, the chosen frequency bandwidth must be higher than the bandwidth of the converter 1312, e.g. when a constant load current is used.

In Fig. 7, controller 1302 is shown again, which may be used for controlling at least the main switches 1304 and 1308, and which also may be used to control the first and second EIS interconnection switches 1322 and 1324 and to operate the converter 1312. The voltmeter 1328 is not mandatory.

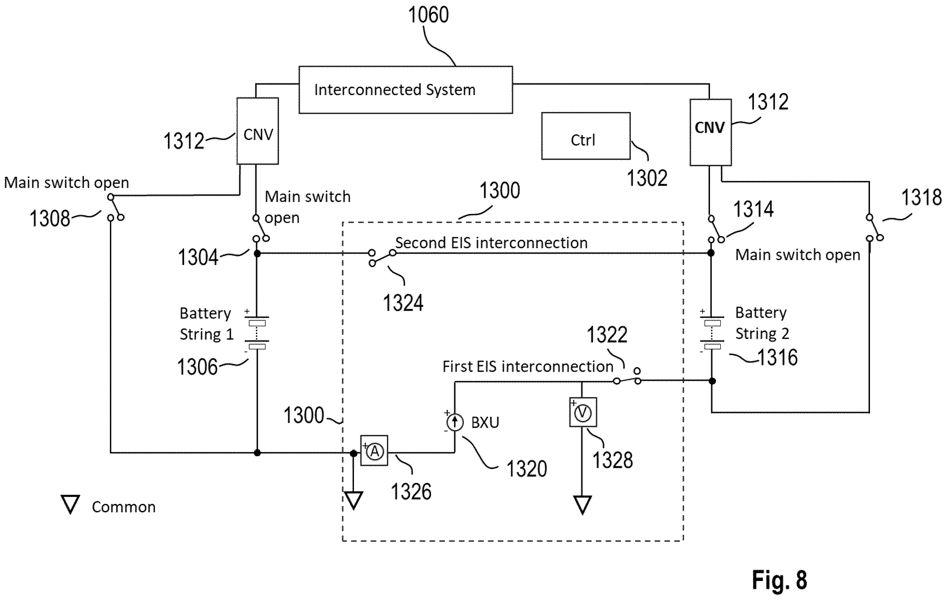

Fig. 8 shows a circuit diagram of a further example. The Battery String to be measured is again the first battery string 1306. The Offset Voltage Device is a second battery string 1316 of the same battery. The first battery string 1306 is connectable at its plus pole terminal to the converter 1312 by main switch 1304 and to common ground by main switch 1308. The second battery string 1316 is connectable at its plus pole terminal to a converter 1312 by main switch 1314 and to common ground by main switch 1318. In the stationary configuration shown in Fig. 8, all main switches are open.

The current source, i.e., BXU, 1320 for the EIS measurement is inserted switchable between the minus poles of the respective battery strings 1306, 1316. The first EIS interconnection switch 1322 connects the second side of the current source 1320 to the minus pole of the second battery string 1316. A second EIS interconnection switch 1324 connects the plus poles of the first 1306 and second 1316 battery strings with each other.

Further elements depicted in Fig. 8 are the BXU current sensor 1326 and the optional BXU voltage sensor 1328, both inside BXU arrangement 1300.

The configuration as shown in Fig. 8 is used for stationary EIS measurements, i.e., the main switches 1304, 1308 are open. The EIS interconnection switches 1322, 1324 are closed to form a loop comprising the first battery string 1306, the current source 1320 and the second battery string 1316, where the current source 1320 injects the current into the second battery strings 1316 and 1306.

The two strings 1306, 1316, are used to keep the voltage present at the output of the OP 1402 (see Fig. 5) very low. The OP therefore only has to compensate for the voltage drop caused by the excitation current at the internal impedance of the strings 1306, 1316. However, this is very small, so that the OP circuit only has to provide or absorb a small amount of electrical power. The two adjacent strings can slightly be misbalanced. The current source 1320 can compensate the difference of the string potentials up to 60V.

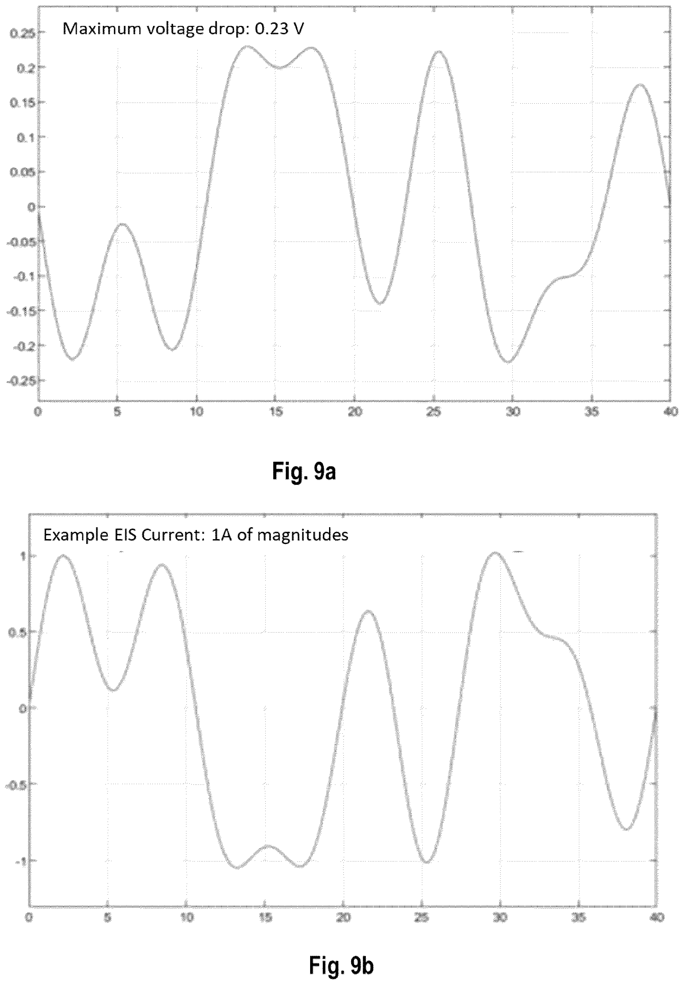

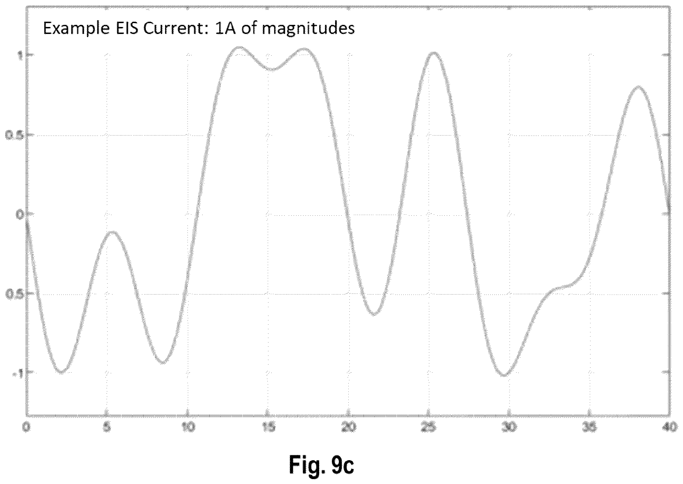

Fig. 9a shows the results of a simulation according to the circuit of Fig. 8. The voltage drop measured by the voltage sensor 1328, Fig. 9b the EIS current through the second battery string 1316, and Fig. 9c the EIS current through the first battery string 1306. The magnitudes of the EIS currents are in the order of 1A. The maximum voltage drop over the output of the BXU is 0.23 V, assuming an impedance of 0.1 Ohm.

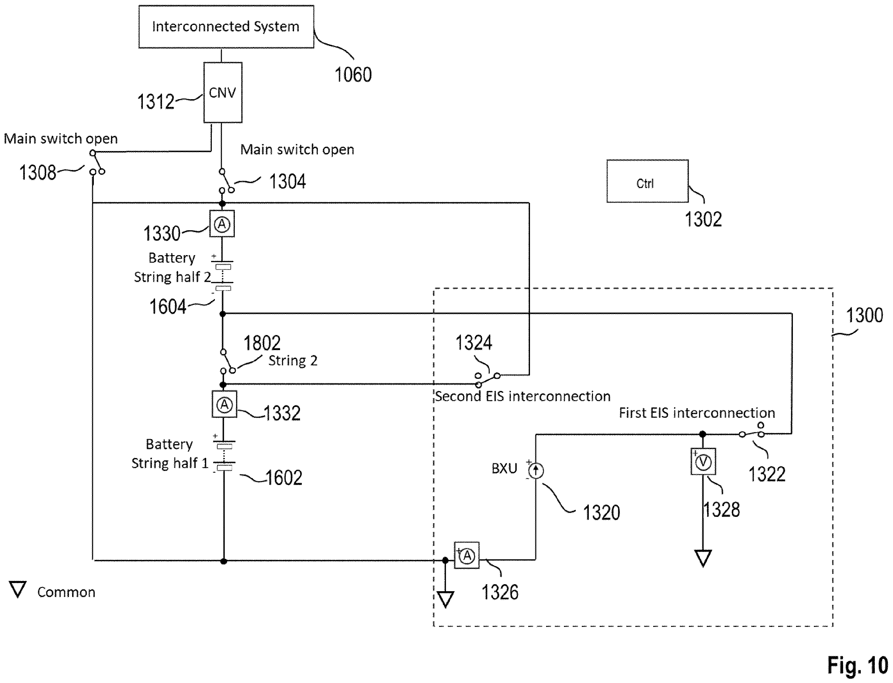

Fig. 10 shows an example of an embodiment, where one battery string 1306 is used. The string 1306 is split into two halves 1602, 1604. Both battery string halves 1602, 1604 are disconnected from each other by means of a middle main switch 1802 during the current injection. Further, the second battery string half 1604 is disconnected from the DC/DC converter 1312. That is, the Battery String to be measured is the first battery string half 1602 and the Offset Voltage Device in this case is the second battery string half 1604. Similar to the two-string-case of Fig. 8, the impedance of both battery string halves 1602, 1604 is measured in a stationary EIS measurement, where the plus terminal of the string is disconnected from the converter 1312 or interconnected system by opening main switches 1304, 1308.

In this case, the current source 1320 injects its current into the minus terminal of the second battery string half 1604, which is in Fig. 10 the upper battery string half 1604, of the battery string 1306. The plus terminal of the second battery string half 1604 of the first battery string 1306 is connected with a second switchable EIS-Interconnection 1324, which is switched on, when the current injection takes place. The second switchable EIS interconnection 1324 is conducting the injected current to the plus terminal of the first battery string half 1602, i.e., the lower part of the first battery string 1306 in Fig 10.

Current sensors 1330 and 1332 are not mandatory for EIS measurement, as for these measurements current sensor 1326 is used.

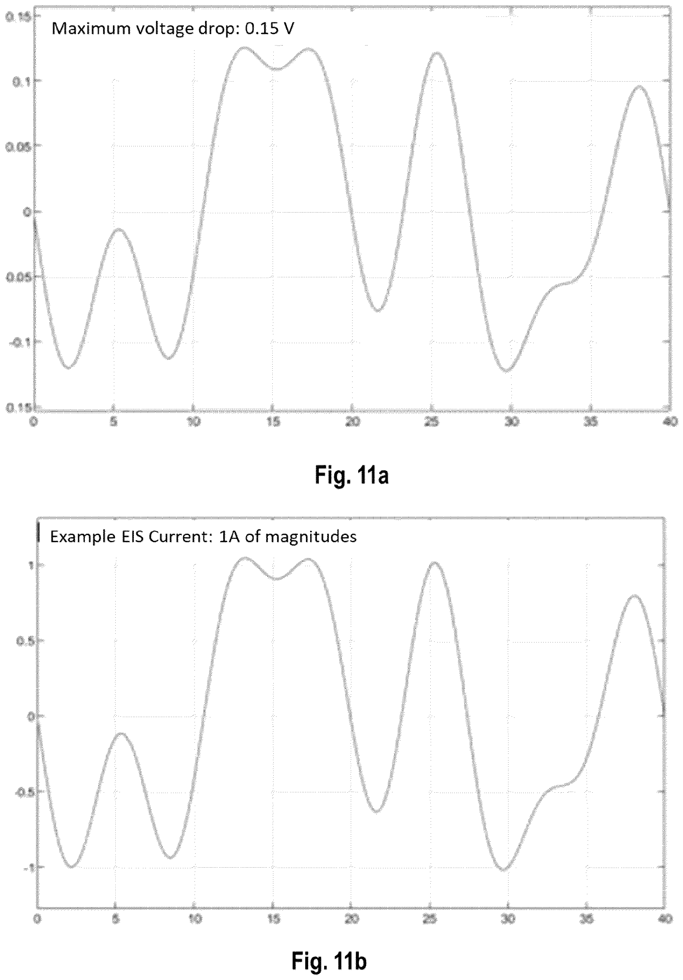

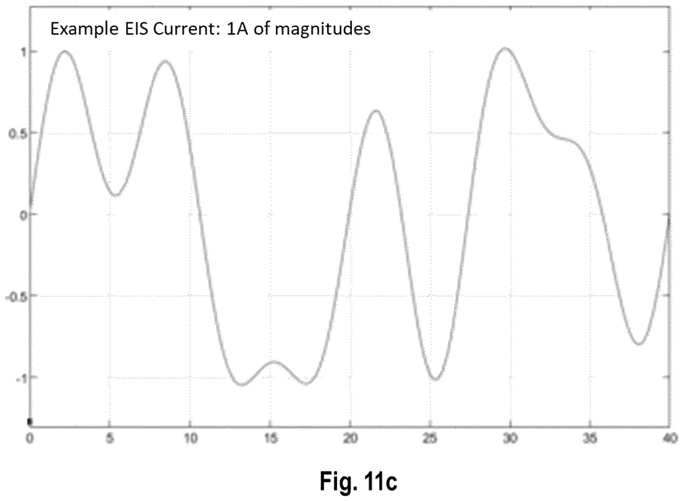

Figs. 11a to 11d show the results of a simulation according to the circuit of Fig. 10. Fig. 11a shows a diagram of the voltage drop measured by the voltage sensor 1328, Fig. 11b shows a diagram of the EIS current through the second battery string half 1604 measured by current sensor 1332, and Fig. 8c a diagram of the EIS current through the first battery string half 1602 measured by current sensor 1330. The magnitude of the EIS currents is in the order of 1A. The maximum voltage drop over the output of the BXU is 0.1 V, assuming an impedance of 0.1 Ohm.

Fig. 12 shows the EIS measurement system with the BMUs 1200 indicated as BMU 1 1201, BMU 2 1202... BMU n, which perform the voltage measurement at the battery cells units 1306. The BMUs 1200 receive a synchronization signal, e.g. from the BXU 1320. For example, the current measurement circuit may generate the synchronization signal, or a microcontroller 1404 (see Fig. 5).

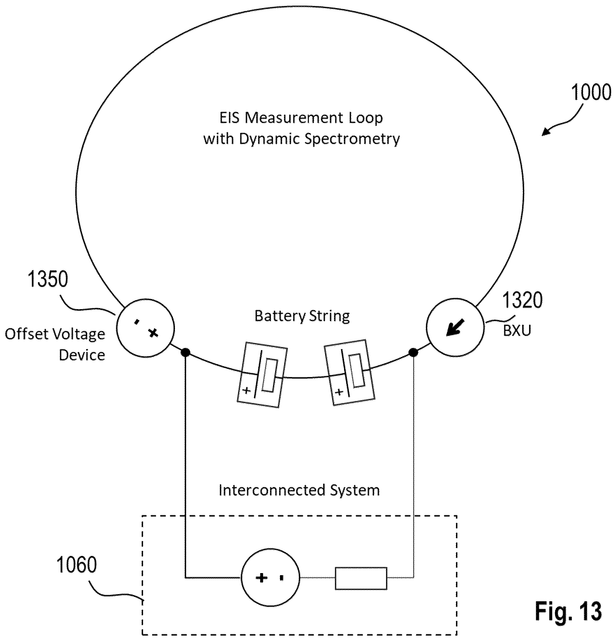

Fig. 13 illustrates the dynamic EIS configuration, i.e. the EIS measurement loop 1000 with dynamic spectrometry. The Battery String is connected in parallel to the interconnected system 1060. The interconnected system 1060 may be a load, a charging system or a combined system as can be found, e.g. in electrical vehicles such as motor vehicles, trains, boats and ships, airplanes, helicopters and the like.

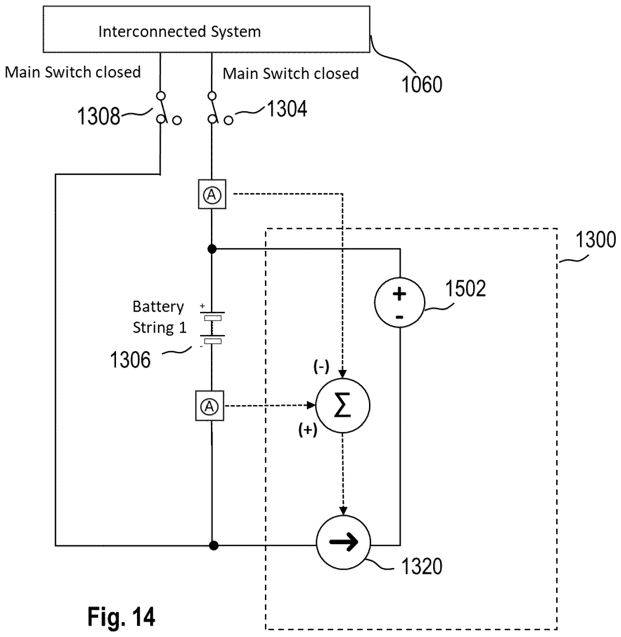

Fig. 14 shows a circuit diagram for dynamic EIS measurements, where the current through the Battery String consists of a leakage current from or to the interconnected system 1060 and the BXU current. The BXU 1320 can equalize the leakage current based on measurements of the total current and the leakage current, where the leakage current is identified by subtracting it from the total current. Of course, the BXU current then is not pure sinusoidal anymore. However, since the currents are known, and since the frequencies differ, the EIS is still precise.

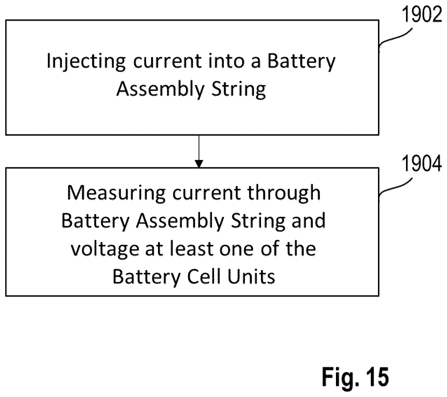

Fig. 15 shows a method for measuring an impedance in an EIS measurement system as described herein, wherein the EIS measurement system comprises a battery excitation unit (BXU), incorporating a bidirectional voltage controlled current source for injecting current into a Battery String comprising a plurality of Battery Cell Units for an EIS measurement, and at least one Offset Voltage Device (OVD); and wherein battery excitation unit is connected in series with the at least one OVD, each of which is configured to provide a voltage with opposite polarity to the Battery String to act as an Offset Voltage to the internal voltage of the Battery Cell Units within the Battery String, such that the BXU largely sees the impedance of the Battery Cell Units within the Battery String to be measured, comprising the steps: injecting 1902 current into a Battery String;
measuring 1904 the current through the Battery String and the voltage at least one of the Battery Cell Units.

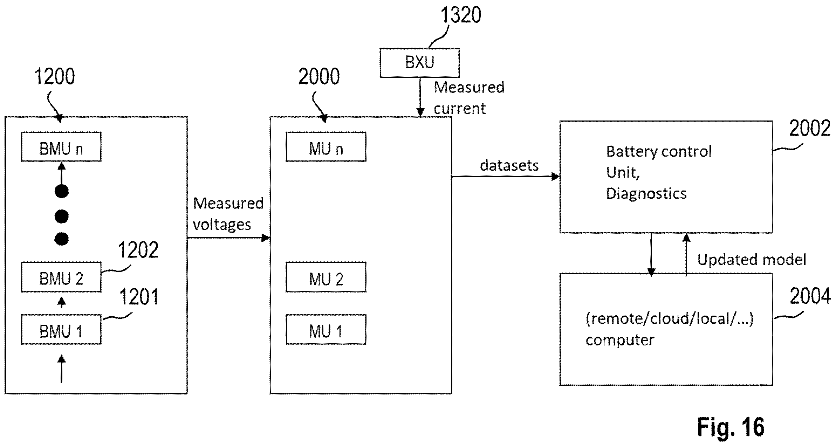

Fig. 16 shows a block diagram of a further embodiment of the EIS measurement system. The EIS measurement system may further comprise a control unit, such as Battery Control Unit 2002 shown in Fig. 15, and one or more Measurement Units 2000. The one or more Measurement Units 2000 may receive the voltage measurements from the BMUs 1200 along with other data such as environment data, e.g. temperature measured at the battery, humidity, chemical and physical parameters, etc., and the current measurements from the BXU 1320, i.e. the detected measured variables. The one or more Measurement Units 2000 may organize the received data in data sets and provide the data sets to the Battery Control Unit 2002. The measurement units may be capable of determining the impedance spectrum such that it can provide the already calculated impedance spectrum to the Battery Control Unit 2002. The data sets may therefore comprise further for each battery cell or Battery Cell Unit the measured currents and voltages per frequency and/or the impedance spectrum values, and a time stamp. By the EIS measurement, a state of the battery is determined. A state is, for example, a state of charge or a "state of health", or a physical or chemical property that can change through the use of the battery or generally over time.

The Battery Control Unit 2002 may be configured to generate a feature data set from the measurement data sets of the measurement units, to apply a time stamp to the feature data set and to temporarily store, i.e. cache, the feature data set including the time stamp. In addition to the time stamp, the characteristic data set can contain, for example, impedance values at frequency support points, as well as current and voltage values, statistical information on measured current and voltage ranges, an SoC, calculated by means of a current integration over the time interval between the last measurement and the current measurement, a temperature, etc.

The EIS measurement system may further comprise a computer 2004 such as computing unit 2004 in Fig. 16 and a communication interface configured to transmit the cached feature data records from the Battery Control Unit 2002 to the computing unit 2004, whereby the computing unit is configured to receive the temporarily stored feature data records and to calculate a model of a machine learning system cyclically or dynamically on the basis of current feature data records, whereby the model provides diagnostic functions for each measuring unit 2000, and the computing unit 2004 is also configured to transmit the model to the Battery Control Unit 2002 via the communication interface. The computing unit 2004 stores all characteristic data records with a time stamp in a database. This creates a digital life/health record that can be used to seamlessly monitor the most important features of the battery system. Even at this stage of the data situation, anomalies in the battery system can be detected at cell unit level through simple checks of range limits. The computing unit 2004 also makes it possible to train updated models using machine learning methods on the basis of the latest feature data sets.

The Battery Control Unit 2002 may be equipped with logic that allows diagnostic functions to be executed. The diagnostic functions are based on a model of a machine learning process. The Battery Control Unit 2002 receives the model or the values of the model parameters via a communication interface from the computing unit 2004.

This means that the computing unit 2004 regularly trains the model and sends the resulting model back to the Battery Control Unit 2002. The Battery Control Unit 2002 then feeds the current characteristic data records into the model. This allows the battery control unit to provide important diagnostic functions that are periodically updated.

The model may be an artificial intelligence model that is further configured to estimate a SoC state value, an SoH state value, a state value with respect to a temperature, a chemical property and/or a physical property.

Other variations of the disclosed embodiments may be understood and carried out by one skilled in the art in practicing the claimed invention by studying the drawings, the disclosure and the appended claims. In the claims, the word "comprising" does not exclude other elements or steps, and the indefinite article "a" or "an" does not exclude a plurality. A single processor or other unit may perform the functions of multiple items or steps recited in the claims. The mere fact that certain actions are recited in interdependent claims does not mean that a combination of those actions cannot be used advantageously. A computer program may be stored / distributed on a suitable medium such as an optical storage medium or a semiconductor medium supplied together with or as part of other hardware, but may also be distributed in other forms, for example via the Internet or other wired or wireless telecommunication systems. Reference signs in the claims should not be construed to limit the scope of the claims.

### Reference Signs

- 1000: EIS measurement loop
- 1001, 1002: battery units
- 1060: Interconnected System
- 1200: BMUs
- 1201: BMU 1
- 1202: BMU 2
- 1300: BXU arrangement
- 1302: controller
- 1304: main switch (plus)
- 1306: first battery string
- 1308: main switch (ground)
- 1312: converter
- 1314: main switch
- 1316: second battery string
- 1318: main switch
- 1320: voltage controlled bidirectional current source, BXU
- 1322, 1324: EIS interconnection switches
- 1326: current sensor
- 1328: optional voltage sensor
- 1330: optional current sensor
- 1332: optional current sensor
- 1340: Battery String
- 1350: Offset Voltage Device, OVD
- 1402: operational amplifier
- 1404: BXU controller
- 1502: Offset Voltage Power Supply
- 1602,: first battery string half of first battery string 1306
- 1604: second battery string half of first battery string 1306
- 1802: middle switch
- 1902, 1904: method steps
- 2000: Measurement Units
- 2002: Battery control Unit, diagnostics
- 2004: (remote/cloud/local/...) computer

## Claims

1. EIS measurement system, comprising
a battery excitation unit (1320), BXU, incorporating a bidirectional voltage controlled current source for injecting current into a Battery String comprising a plurality of Battery Cell Units for an EIS measurement, and
at least one Offset Voltage Device, OVD, (1350);
wherein the BXU (1320) is connected in series with the at least one OVD (1350), each of which is configured to provide a voltage with opposite polarity to the Battery String to act as an Offset Voltage to the internal voltage of the Battery Cell Units within the Battery String.

2. EIS measurement system according to claim 1,
wherein the EIS measurement system further comprises one or more BMUs (1200), each associated a Battery Cell Unit to measure the voltage response of its corresponding Battery Cell Unit and to perform the EIS measurement of each Battery cell unit.

3. EIS measurement system according to any of the previous claims, wherein the EIS measurement system further comprises a current sensor (1326) for measuring the EIS current and which is used for the excitation of the EIS current into the battery-string.

4. EIS measurement system according to claim 1 or 2, wherein at least one of the Offset Voltage Devices (1350) is a power supply or a voltage source (1502).

5. EIS measurement system according to claim 4, wherein the voltage of the power supply voltage source is adjusted as a function of the state of charge or open circuit voltage of the Battery String to be measured thereby minimizing the voltage differential between the OVD (1350) and the internal voltage of the Battery cell units within the Battery String.

6. EIS measurement system according to any one of the previous claims, wherein at least one of the OVDs (1350) is a Battery Cell Unit.

7. EIS measurement system according to the previous claims, further comprising a switching matrix configured to be controlled such that, for an EIS measurement, at least one of the Battery Cell Units is switched into the Battery String in series with the BXU (1320).

8. EIS measurement system according to the previous claim, wherein the switching matrix is configured to be controlled such that, for an EIS measurement, at least one of the OVDs (1350) is switched into the Battery String in series with the BXU (1320).

9. EIS measurement system according to claims 7 or 8, wherein the switching matrix is configured to be controlled such that, for an EIS measurement, a first Battery String of the Battery Assembly is switched into the Battery String Assembly, and a second Battery String of the Battery Assembly is switched into the Battery String Assembly as OVD (1350).

10. EIS measurement system according to any of claims 7 to 9, wherein the switching matrix comprises main switches that connect battery strings to an interconnected DC system.

11. EIS measurement system according to any of claims 7 or 8, wherein the switching matrix is configured to be controlled such that, for an EIS measurement, a Battery String is divided into a first battery string half and a second battery string half, wherein the second battery string half is switched as OVD (1350).

12. EIS measurement system according to claim 10, wherein,
in case of stationary impedance spectrometry measurement, the main switches are open such that at least one battery string are disconnected from an interconnected DC system (1060).

13. EIS measurement system according to claim 10, wherein,
in case of dynamic impedance spectrometry measurement, the main switches are closed such that at least one battery string is connected to the interconnected DC system and the is battery string operable during the EIS measurement.

14. EIS measurement system according to claim 12, wherein,
in case of dynamic Dynamic Spectrometry measurement, the EIS measurement system configured to place a current sensor for the excitation in series with a terminal of the Battery String Assembly to be measured such that it measures the current flow from its interconnected system (1060) and the BXU (1320).

15. EIS measurement system according to any one of the previous claims, wherein the bidirectional voltage controlled current source for the BXU (1320) is realized by an operational amplifier (1402) or a DC/DC converter (1312).

16. EIS measurement system according to any one of claims 2-15, further comprising a
a battery control unit configured to receive measurement data sets from the BMUs and the BXU and/or a measurement unit connected to the BMUs or BXU; and
a computing unit and a communication interface, which are configured to transmit temporarily stored feature data records to the computing unit, wherein the computing unit is configured to receive the temporarily stored feature data records and to cyclically calculate a model of a machine learning system, wherein the model provides diagnostic functions for each measuring unit on the basis of current feature data records, and the computing unit is furthermore configured to transmit the model via the communication interface to the battery control unit.

17. Method for measuring an impedance in an EIS measurement system according to any one of claims 1 to 16, wherein the EIS measurement system comprises a battery excitation unit (1320), BXU, incorporating a bidirectional voltage controlled current source for injecting current into a Battery String comprising a plurality of Battery Cell Units for an EIS measurement, and at least one Offset Voltage Device, OVD, (1350); and wherein battery excitation unit is connected in series with the at least one OVD (1350), each of which is configured to provide a voltage with opposite polarity to the Battery String to act as an Offset Voltage to the internal voltage of the Battery Cell Units within the Battery String, such that the BXU (1320) largely sees the impedance of the Battery Cell Units within the Battery String to be measured, comprising the steps:
injecting (1902) current into a Battery String;
measuring (1904) the current through the Battery String and the voltage at least one of the Battery Cell Units.
